# EUROPÄISCHE PATENTSCHRIFT

(11) **EP 0 584 866 B1**
(45) Veröffentlichungstag und Bekanntmachung des Hinweises auf die Patenterteilung: **08.07.1998**
(21) Anmeldenummer: 93202411.0
(22) Anmeldetag: 17.08.1993
(51) Int. Cl.: G01R 33/035, G12B 17/02

(54) **SQUID-Magnetometer mit einer Abschirmhülle gegen elektromagnetische Störfelder**
Squid-magnetometer with a shielding envelope against electromagnetic interference fields
Magnétomètre à Squid avec une enveloppe de blindage contre des champs électromagnétiques parasites

(30) Priorität: 22.08.1992 DE 4227878
(43) Veröffentlichungstag der Anmeldung: 02.03.1994
(73) Patentinhaber: Philips Patentverwaltung GmbH, 22335 Hamburg (DE); Philips Electronics N.V., 5621 BA Eindhoven (NL)
(72) Erfinder: Lüdeke, Kai-Michael, c/o PHILIPS PATENTVERWALTUNG, D-20097 Hamburg (DE); Dössel, Olaf H., Dr., c/o PHILIPS PATENTVERWALTUNG, D-20097 Hamburg (DE); Köhler, Jürgen, c/o PHILIPS PATENTVERWALTUNG, D-20097 Hamburg (DE)
(74) Vertreter: Hartmann, Heinrich, Dipl.-Ing.

(56) Entgegenhaltungen:
- REVIEW OF SCIENTIFIC INSTRUMENTS, Bd.53, Nr.12, Dezember 1982, NEW YORK US Seiten 1815 - 1845 G.L.ROMANI ET AL. 'Biomagnetic Instrumentation'
- J.PHYS. E: SCI. INSTRUM., Bd.13, 1980, GB Seiten 801 - 813 S.J.SWITHENBY 'SQUIDS and their applications in the measurement of weak magnetic fields'

## Beschreibung

Die Erfindung betrifft ein SQUID-Magnetometer mit einer Abschirmhülle gemäß dem Oberbegriff des Anspruchs 1.

Die in bekannten SQUID-Magnetometern, wie z.B. in "A modular low noise 7-channel SQUID-magnetometer", IEEE Transactions of Magnetics, Vol.27, No.2, March 1991, pp. 2797-2800, eingesetzten SQUID's reagieren nicht nur auf das zu messende Magnetfeld, sondern wegen ihrer nichtlinearen Strom-Spannungskennlinie mit Krümmung im Mikrovoltbereich auch empfindlich auf elektrische Störfelder.

Die Zuleitungen zum SQUID wirken dabei als kurze Antennen, die z.B. hochfrequente Signale von Rundfunksendern oder die Störstrahlung von Computern zum SQUID transportieren und seine Funktion als Magnetfeldsensor beeinträchtigen oder bei größerer Feldstärke sogar verhindern. Der Einsatz von Filtern zwischen dem SQUID und den Zuleitungen ist nicht möglich, da aufgrund der typischen Fluß- und Bias-Modulationsverfahren die Steuer- und Meßsignale des SQUID's selbst hochfrequenter Natur sind. Ohne weitere Maßnahmen ist daher der Betrieb eines SQUID-Magnetometers nur innerhalb einer auch als Faraday-Käfig ausgebildeten abgeschirmten Meßkammer möglich. Viele übliche elektronische Meßgeräte können dann in der Meßkammer, in der auch das SQUID-Magnetometer angeordnet ist, wegen der von Ihnen erzeugten Störstrahlung nicht benutzt werden. Nach dem Betreten und Verlassen der Meßkammer muß vor Beginn der Messung erst eine Beruhigungsphase abgewartet werden, in der die sich durch die bei offener Tür eingedrungene Störstrahlung verschobenen Arbeitspunkte des SQUID's und der nachgeordneten Elektronik wieder auf die richtigen Werte einstellen können.

Die Empfindlichkeit von SQUID-Magnetometern gegenüber elektrischen Störungen soll daher soweit verringert werden, daß die o.g. Betriebsbeschränkungen entfallen, indem der Kryostat selbst als Faraday-Käfig ausgebildet wird. Hierzu muß der Kryostat mit einer geschlossenen metallischen Hülle bedeckt werden. Neben der gewünschten Schirmwirkung treten hierbei jedoch zwei andere physikalische Effekte in Erscheinung, die prinzipiell die Magnetfeldmessung beeinträchtigen können.

So regen zeitveränderliche Magnetfelder, z.B. die zu messenden biomagnetischen Signale, in einer solchen Metallhülle Wirbelströme an, die die Größe und den räumlichen Verlauf des Magnetfeldes im Inneren des Kryostaten am Ort des SQUID's verfälschen. Ferner führen freie Elektronen in der Metallhülle die sogenannte Brown'sche Bewegung aus und erzeugen somit thermisches Magnetfeldrauschen, das die Empfindlichkeit des SQUID-Magnetometers verringert.

Mit den aus dem Lehrbuch "Eddy Currents in Linear Conducting Media", Elsevier Science Publishers B.V. 1985, bekannten Methoden lassen sich die Magnetfeldverzerrungen durch Wirbelströme für einfache Schirmgeometrien exakt berechnen und für komplexere Formen hinreichend genau abschätzen.

Verfahren zur Ermittlung des Magnetfeldrauschens von normalleitenden Metallen in der Nähe von Magnetometern und Gradiometern sind beispielsweise aus dem Aufsatz "Johnson noise from normal metal near a superconducting SQUID gradiometer circuit", IEEE Transactions of Magnetics, Vol. 23, No. 2, March 1987, pp. 1093-1096, und aus dem Aufsatz "Thermal noise of a biomagnetic measurement dewar, Advances in Biomagnetism", 1989, pp. 729-732, bekannt. Die aus dem zuletzt genannten Aufsatz bekannte und verwendete Aluminiumfolie ist verhältnismäßig dick, so daß sie, um zu starkes Rauschen zu vermeiden, nicht vollständig geschlossen sondern in einzelne fladenähnliche Abschnitte aufgeteilt im Inneren des Kryostaten angeordnet ist. Durch diese Aufteilung ist eine vollständige Hochfrequenzschirmung nicht mehr gegeben. Ferner kann eine Schirmung nicht nachträglich angebracht werden.

Aus dem Abstract JP-A-62-175681 ist eine Hochfrequenzabschirmung durch eine Aluminiumfolie, die innerhalb einer Außenwand eines doppelwandigen Kryostaten angeordnet ist, bekannt. Die Folien sind jedoch nicht zu einer geschlossenen Hülle verbunden, weshalb nicht die gewünschte Schirmwirkung einer geschlossenen Hülle erreichbar ist.

Aus der EP-A1-0 401 420 ist eine Hochfrequenzabschirmung innerhalb eines Dewar-Gefässes bekannt, die eine aufwendige Konstruktion aus mehreren Einzelteilen mit teilweise komplexer Struktur aufweist, die in einer Vielzahl von Arbeitsgängen erstellt und zusammengefügt werden müssen. Um eine Erhöhung des Systemrauschens durch thermische Wirbelströme im Schirmmaterial zu vermeiden, ist die Abschirmung gerade im Abschnitt höchster Empfindlichkeit, also bei den Gradiometern, nicht geschlossen, denn eine praktisch vollständige Umhüllung eines SQUID-Systems mit einer geschlossenen Metallfläche führt, wie der E-A1-0 401 420 zu entnehmen ist, zu thermisch bedingten Wirbelströmen, die mit einer Verschlechterung des Signal-Rausch-Verhältnisses verbunden sind. Im Bereich der supraleitenden Teile ist die Hochfrequenzabschirmung daher in einzelne elektrisch leitende, untereinander isolierte Leiterbahnen aufgeteilt, wodurch selbstverständlich wieder nachteilig die Abschirmwirkung beeinträchtigt wird.

Aus Rev. Sci. Instr., Vol. 53, No. 12, December 1982, Seiten 1815 bis 1845, g.l. Romani et al. "Biomagnetic instrumentation" ist eine Abschrimhülle für SQUID-Magnetometer gegen elektromagnetische Störfelder aus elektrisch leitfähigem Schirmmaterial, beispielsweise eine Aluminium- oder Kupferfolie bekannt. Zur Rauschminimierung soll der elektrische Widerstand der Abschirmhülle möglichst hoch sein.

Der Erfindung liegt daher die Aufgabe zugrunde, für eine Abschirmung um den Kryostaten herum ein SQUID-Magnetometer mit einer Abschirmhülle mit bestimmten Eigenschaften anzugeben, die sowohl eine ausreichende Hochfrequenzabschirmung als auch einen akzeptablen niedrigen Rauschbeitrag gewährleistet.

Diese Aufgabe wird durch das in Anspruch 1 angegebene SQUID-Magnetometer gelöst.

Weitere bevorzugte Ausgestaltungen der Erfindung ergeben sich aus den Unteransprüchen.

Aus der genannten Literatur lassen sich die zuvor genannten beiden Effekte bei dünnen metallischen Schichten auf einen Flächenwiderstand R = 1/(s·t) zurückführen, wobei s die Leitfähigkeit und t die Schichtdicke des Schirmmaterials bezeichnen.

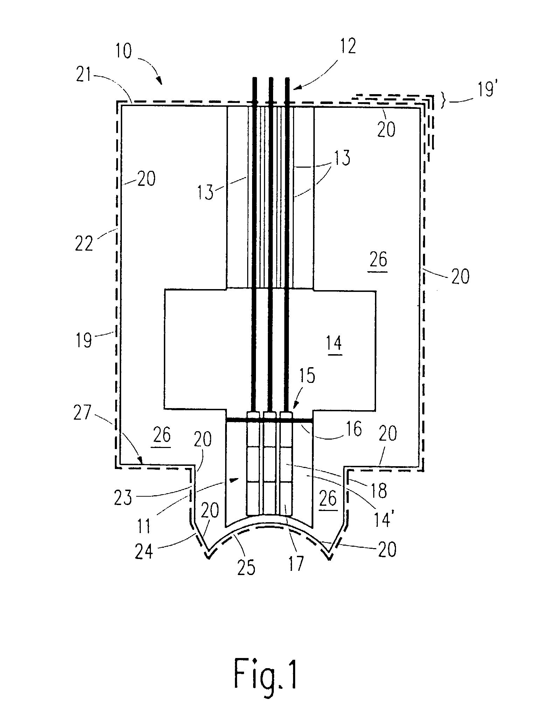

Anhand einer Berechnung des Feldrauschens bei einem Kryostaten, wie er beispielsweise aus der weiter unten beschriebenen Fig. 1 hervorgeht, mit einer Kupferabschirmhülle, die beispielsweise eine Stärke von 35 µm aufweist, wie sie im Stand der Technik bekannt ist, kann gezeigt werden, daß diese Folie mit einem Flächenwiderstand von ca. R = 0,45 mΩ/^{□} zu großen Verzerrungen (im Prozentbereich) bei Frequenzen bis 100 Hz führt, vor allem aber zu viel zu hohem Magnetfeldrauschen. Bei dieser Umhüllung des zu schirmenden Kryostaten wird dann in der zum Kryostaten hinweisenden Spule des Gradiometers mit ca. 1 bis 2 cm Abstand von der kugelkalottenförmigen unteren Seite des Kryostatenendes ein Rauschfluß induziert, der einem Feldrauschen von etwa 40 fT/Hz^{½} (= 40 · 10⁻¹⁵ T/Hz^{½}) entspricht, wobei ca. 37 fT von der Kalotte von und 13 fT vom zylinderförmigen Teil des unteren Ende des Kryostaten herrühren. Die übrigen Teile der Abschirmhülle des Kryostaten tragen infolge größeren Abstandes bereits deutlich weniger zum Gesamtrauschen bei.

Bei einem axialen Gradiometer, das beispielhaft zur Anwendung kommen kann, ist der Gesamtrauschfluß an den Gradiometeranschlüssen etwas kleiner als das soeben berechnete Feldrauschen. Bei einem lateralen Gradiometer kann es auch größer sein.

Bei SQUID-Magnetometern wird jedoch meist ein äquivalentes Systemrauschen unterhalb von 20 fT/Hz^{½} angestrebt, um brauchbare Meßergebnisse zu erhalten.

Bei dem aus dem genannten Aufsatz "A modular low noise 7-channel SQUID-magnetometer" bekannten SQUID-Magnetometer werden sogar 10 fT/Hz^{½} erreicht, bei Abwesenheit von Hochfrequenzstörungen. Um nun für eine erfindungsgemäße Abschirmhülle um den Kryostaten herum einen Flächenwiderstand zu finden, bei dem sowohl eine ausreichende Hochfrequenzabschirmung als auch ein akzeptabel niedriger Rauschbeitrag erreicht wird, kann folgendermaßen vorgegangen werden.

Bei unveränderter Geometrie ist der Rauschbeitrag proportional zu 1/R^{½}. Wird eine geringfügige, beispielsweise nur 10 %-ige Anhebung des Systemrauschens durch die Hochfrequenzabschirmhülle erlaubt, so muß der Rauschbeitrag der Abschirmhülle auf 46 % des Grundrauschens reduziert werden. Die Rauschbeiträge addieren sich quadratisch. Bei dem o.g. 10 fT/Hz^{½} System also auf 4 - 5 fT/Hz^{½}. Dies wird bei der 10 %-igen Anhebung erreicht durch einen Flächenwiderstand der Abschirmhülle im Bereich von ca. 50 bis 70 mΩ/^{□}. Die Magnetfeldverzerrungen durch Wirbelströme sind dann auch vernachlässigbar klein. Bei einer anderen zulässigen Anhebung verändert sich der Bereich des erforderlichen Flächenwiderstandes entsprechend.

Dieser Flächenwiderstand läßt sich z.B. durch Kunststoffolien oder durch Metallfolien aus Kupfer mit einer Dicke von ca. 0,3 µm oder Aluminium mit einer Dicke von ca. 0,6 µm realisieren. Metallfolien haben, dies sei hier erwähnt, jedoch wieder den Nachteil, daß die Herstellung einer geschlossenen Hülle auf in der Regel nicht mehr ganz einfachen Kryostatformen umständliche Arbeitsvorgänge erfordern, wie z.B. Erstellen von Teilschirmen, Zusammenfügen z.B. durch Löten dieser Teilschirme etc. Einfacher ist die Realisierung durch Auftragen eines farbähnlichen elektrisch leitenden Schirmmaterials z.B. auf Silberbasis, wobei über die Anzahl der Aufträge und die Temperatur des Trocknungsvorganges auch noch auf einfache Weise der vorbestimmte gewünschte Flächenwiderstand gezielt erreicht werden kann.

Ein Ausführungsbeispiel wird nachfolgend unter Bezugnahme auf eine Zeichnung näher erläutert. Darin zeigt die einzige Fig. 1 einen Kryostaten für SQUID-Magnetometer mit einer erfindungsgemäßen Abschirmhülle.

Die einzige Fig. 1 zeigt einen von sich aus nicht schirmenden Kryostaten 10 beispielsweise aus glasfaserverstärktem Kunststoff (GFK) für ein Vielkanal-SQUID-Magnetometer 11, dessen Anschlüsse 12 durch Führungsrohre 13 in einen mit Helium gefüllten Abschnitt 14 geführt werden, in dessen unterem Abschnitt 14' sich dann die eigentlichen SQUID-Gehäuse 15 befinden und über eine Lochführungsplatte 16 fixiert sind und u.a. die eigentlichen Gradiometer 17 und einen Adapter 18 enthalten.

Die erfindungsgemäß mit einer Abschirmhülle 19 zu beschichtende Außenfläche 20 des Kryostats 10 kann beispielsweise grundsätzlich zylinderförmig ausgebildet sein und einen in der Fig. 1 oberen Deckel 21, einen oberen dickeren zylinderförmigen Abschnitt 22, einen scheibenförmigen Abschnitt 27, einen unteren dünneren zylinderförmigen Abschnitt 23 aufweisen und über einen angefasten Abschnitt 24 mit einem kalottenförmigen abschließenden Abschnitt 25 versehen sein.

Unterhalb des unteren kalottenförmigen Abschnittes 25 kann beispielsweise ein zu untersuchender menschlicher Kopf positioniert werden. Ins Innere weisend ist der Kryostat wie üblich doppelwandig ausgeführt und weist somit eine Vakuumisolationsschicht 26 auf. Bei einem Kryostaten 10 entsprechend Fig. 1 wird in der untersten Spule des Gradiometers 17 in einem Abstand von etwa 1 - 2 cm vom kalottenförmigen Abschnitt 25 des unteren Abschnittes des Kyrostaten 10 ein Rauschfluß induziert, der insgesamt der gewünschten Größe des Feldrauschens entspricht, wobei ca. drei Viertel vom kalottenförmigen Abschnitt 25 und ein Viertel vom zylinderförmigen Teil 23 inklusive der Anfasung 24 herrühren. Die übrigen Abschnitte 21, 22 und der ringförmige Abschnitt 27 tragen in Folge größeren Abstands deutlich weniger zum Gesamtrauschen bei.

Bei dieser Geometrie ist der Rauschbeitrag proportional zu R^{-½}. Wird eine 10 %-ige Anhebung des Systemrauschens durch die erfindungsgemäße Abschirmhülle 19 erlaubt, so muß der Rauschbeitrag der Abschirmhülle 19 auf 46 % des Grundrauschens reduziert werden. Da sich die Rauschbeiträge quadratisch addieren, ergibt sich vorliegend bei dem System, das in Abwesenheit von Hochfrequenzstörungen 10 fT/Hz^{½} aufweist, ein Rauschbeitrag von 4 - 5 fT/Hz^{½}. Dies wird dadurch erreicht, daß der Flächenwiderstand bei 10 %-iger Anhebung im Bereich zwischen ca. 50 - 70 mΩ/^{□} liegt und erfindungsgemäß reproduzierbar und gleichmäßig auf die Außenfläche 20 des Kryostaten 10 aufgebracht wurde. Eine andere zulässige Anhebung ergibt einen anderen vorbestimmbaren Flächenwiderstandsbereich. Durch diese erfindungsgemäße Abschirmhülle 19 werden auch Wirbelströme vernachlässigbar klein.

Der Flächenwiderstand läßt sich z.B. auch realisieren durch Schirmmaterial, wie Folien aus Kunststoff oder aus Kupfer mit einer Dicke von ca. 0,3 µm oder aus Aluminium mit einer Dicke von ca. 0,6 µm. Metallfolien haben allerdings den Nachteil, daß die Herstellung einer geschlossenen Hülle auf einer nicht mehr ganz einfachen Kryostatform, wie z.B. des Kryostaten 10, umständliche Arbeitsvorgänge erfordern (z.B. Herstellen von Teilfolien, Zusammenfügen dieser durch z.B. Löten, etc.). Einfacher ist die Realisierung durch erfindungsgemäßes Auftragen elektrisch leitfähigen farbähnlichen Schichtmaterials 19 z.B. auf Silberbasis, wobei über die Anzahl der Farbaufträge und die Temperatur des Trocknungsvorganges auch noch in einfacher Weise der gewünschte Flächenwiderstand genau gesteuert werden kann.

Die Abschirmhülle 19 des erfindungsgemäßen SQUID-Magnetometers weist somit ein- oder mehrschichtig aufgetragen, in Fig. 1 oben rechts durch mehrere unterbrochene Linien 19' angedeutet, einen Flächenwiderstand von ca. 50 - 70 mΩ/^{□} auf. Sie kann dazu aus elektrisch leitfähigem farbähnlichem Material z.B. auf Silberbasis aufgebaut sein. Es können auch Kombinationen von Teilfolien und farbähnlichem Schichtmaterial vorgesehen sein, wobei dann der Gesamtflächenwiderstand ca. 50 - 70 mΩ/^{□} betragen soll. Das farbähnliche Schichtmaterial kann schichtweise aufgetragen oder aufgespritzt und getrocknet werden, wobei bei mehreren Schichten dann wieder der Gesamtflächenwiderstand von ca. 50 - 70 mΩ/^{□} erreicht werden soll.

Die anmeldungsgemäße Abschirmhülle 19 bildet somit einen geschlossenen Hochfrequenzschirm für den ganzen Kryostaten 10, die in einem einfachen Arbeitsgang sogar auf vorhandene Kryostaten nachträglich aufgebracht werden kann und nicht nur bei dessen Herstellung, wie z.B. im Stand der Technik nach der genannten JP-A-62-175681 oder der EP-A1-0 401 420. Das durch die erfindungsgemäße Abschirmhülle 19 zusätzlich verursachte Rauschen ist, wie ausgeführt, vernachlässigbar klein.

## Patentansprüche

1. SQUID-Magnetometer mit einer Abschirmhülle (19) gegen elektromagnetische Störfelder, wobei die Abschirmhülle (19) einen von sich aus nicht schirmenden Kryostaten (10) des SQUID-Magnetometers (11) vollständig umschließt, aus mindestens einer Schicht eines elektrisch leitfähigen Schirmmaterials aufgebaut ist und einen derart vorbestimmten Flächenwiderstand aufweist, daß durch die Abschirmhülle (19) sowohl eine ausreichende Hochfrequenzabschirmung als auch ein akzeptabel niedriger Rauschbeitrag gewährleistet ist,
dadurch gekennzeichnet, daß die Abschirmhülle (19) aus mindestens einer auf den Kryostaten (10) aufgetragenen farbähnlichen elektrisch leitenden Schicht des Schirmmaterials besteht.

2. Abschirmhülle nach Anspruch 1,
dadurch gekennzeichnet, daß die Abschirmhülle (19) aus Schichtmaterial besteht, das ein- oder mehrschichtig aufgetragen für eine ca. 10 %-ige Anhebung des Systemrauschens einen Flächenwiderstand von ca. 50 - 70 mΩ/^{□} aufweist.

3. Abschirmhülle nach Anspruch 2,
dadurch gekennzeichnet, daß das Schichtmaterial der Abschirmhülle (19) aus Schirmmaterial auf Silberbasis aufgebaut ist.

4. Abschirmhülle nach Anspruch 3,
dadurch gekennzeichnet, daß mehrere Schichten des farbähnlichen Schirmmaterials je Schicht aufgestrichen oder aufgespritzt und getrocknet sind und gezielt einen Gesamtflächenwiderstand von ca. 50 - 70 mΩ/^{□} aufweisen.

5. Abschirmhülle nach einem oder mehreren der vorhergehenden Ansprüche,
dadurch gekennzeichnet, daß die Abschirmhülle (19) aus einer Kombination von Metallfolien und farbähnlichem Schichtmaterial mit einem Gesamtflächenwiderstand von ca. 50 - 70 mΩ/^{□} aufgebaut ist.

## Claims

1. A SQUID-magnetometer which comprises a shielding envelope (19) against electromagnetic interference fields, the shielding envelope (19) fully enclosing a non-shielding cryostat (10) of the SQUID-magnetometer (11), being composed of at least one layer of an electrically conductive shielding material, and having a predetermined sheet resistance such that the shielding envelope (19) ensures adequate RF shielding as well as an acceptably low noise contribution,
characterized in that the shielding envelope (19) consists of at least one lacquer-like, electrically conductive layer of the shielding material which is applied to the cryostat (10).

2. A shielding envelope as claimed in Claim 1,
characterized in that the shielding envelope (19) consists of a layer material which is applied in one or more layers and has a sheet resistance of from approximately 50 to 70 mΩ/□ with an increase of the system noise of approximately 10%.

3. A shielding envelope as claimed in Claim 2,
characterized in that the layer material of the shielding envelope (19) consists of a shielding material on the basis of silver.

4. A shielding envelope as claimed in Claim 3,
characterized in that several layers of the lacquer-like shielding material are applied individually per brush or by spraying, followed by drying, said layers together having a desired overall sheet resistance of from approximately 50 to 70 mΩ/□.

5. A shielding envelope as claimed in one or more of the preceding Claims,
characterized in that the shielding envelope (19) consists of a combination of metal foils and a lacquer-like layer material with an overall sheet resistance of from approximately 50 to 70 mΩ/□.

## Revendications

1. Magnétomètre à SQUID avec une enveloppe de blindage (19) contre les champs parasites électromagnétiques, l'enveloppe de blindage (19) renfermant complètement un cryostat (10) non protecteur en soi du magnétomètre à SQUID (11), étant composé d'au moins une couche d'un matériau de blindage électriquement conducteur et présentant une résistance de surface prédéterminée telle qu'une protection de haute fréquence suffisante et une contribution au bruit inférieure acceptable sont garanties par l'enveloppe de blindage (19), caractérisé en ce que l'enveloppe de blindage (19) se compose d'au moins une couche de matériau de blindage électriquement conductrice et semblable à de la couleur appliquée sur le cryostat (10).

2. Enveloppe de blindage selon la revendication 1, caractérisée en ce que l'enveloppe de blindage (19) se compose d'un matériau en couche qui est appliqué en une ou plusieurs couches et présente pour une augmentation d'environ 10% du bruit du système une résistance de surface d'environ 50-70 mΩ/^{□}.

3. Enveloppe de blindage selon la revendication 2, caractérisée en ce que le matériau en couche de l'enveloppe de blindage (19) est composé d'un matériau de blindage à base d'argent.

4. Enveloppe de blindage selon la revendication 3, caractérisée en ce que plusieurs couches du matériau de blindage semblable à de la couleur sont appliquées ou injectées par couche et ensuite séchées et présentent délibérément une résistance de surface globale d'environ 50-70 mΩ/^{□}.

5. Enveloppe de blindage selon l'une ou plusieurs des revendications précédentes, caractérisée en ce que l'enveloppe de blindage (19) se compose d'une combinaison de feuilles métalliques et d'un matériau en couche semblable à de la couleur avec une résistance de surface globale d'environ 50-70 mΩ/^{□} .
